# EUROPEAN PATENT SPECIFICATION

(11) **EP 2 581 934 B1**
(45) Date of publication and mention of the grant of the patent: **15.08.2018**
(21) Application number: 12188485.2
(22) Date of filing: 15.10.2012
(51) Int. Cl.: H01L 21/677, B65G 49/06, C23C 16/54, B23K 26/36, H01L 21/67

(54) **Apparatus and method for the production of photovoltaic modules**
Vorrichtung und Verfahren zur Herstellung photovoltaischer Module
Appareil et méthode pour la production de modules photovoltaïques

(30) Priority: 14.10.2011 IT UD20110164; 04.05.2012 US 201261643117 P
(43) Date of publication of application: 17.04.2013
(73) Proprietor: APPLIED MATERIALS ITALIA S.R.L., 31048 San Biagio di Callalta (TV) (IT)
(72) Inventor: Baccini, Andrea, 31030 Mignagola di Carbonera (TV) (IT); Gajotto, Marco, 31030 Dosson Di Casier (TV) (IT); Micheletti, Thomas, 38068 Rovereto (TN) (IT); Tonini, Diego, 31100 Treviso (IT); Telle, John, Albuquerque, NM 87109 (US); Maiolini, Marco, 30173 Mestre (VE) (IT); Sartoretto, Andrea, 35010 Loreggia (PD) (IT)
(74) Representative: Zimmermann & Partner Patentanwälte mbB

(56) References cited:
- EP-A1- 2 224 499
- WO-A1-2009/029901
- WO-A1-2009/150239
- US-A1- 2010 162 954

## Description

### BACKGROUND OF THE INVENTION

### Field of the Invention

The present invention relates to an apparatus and a method for the automated production of photovoltaic modules.

### Description of the Related Art

Conventional solar cell processing systems typically form photovoltaic modules, which contain many solar cell substrates, by stacking the various required components, or layers, of the photovoltaic module one on top of the other in a minimally or non-automated system that is arranged in a linear manner along a single longitudinal axis, or work line. Typically, the different positioning stations in the system are disposed along the work line, wherein the system will generally comprise a handling device to handle the basic printed circuits, a print device to make the necessary electric contacts, a device to prepare the layers of insulating material to be associated with the printed circuits, a device to position the individual photovoltaic cells and a series of optical inspection devices. In conventional photovoltaic module processing systems, the various parts that form each photovoltaic module are moved between stations by trolleys.

US 2010/0162954 A1 discloses a process module facility, comprising at least one process chamber carried in frame, a subfloor adjacent the process module, a stationary pump and electrical box positioned atop the subfloor, and gas control lines and vacuum exhaust lines housed within the subfloor and coupled to the process chamber. The process module facility may be integrated with a larger system for processing substrates which includes two or more process module facilities, a substrate handling robot, a load lock chamber, and a transverse substrate handler. The transverse substrate handler includes mobile transverse chambers configured to convey substrates to process modules, wherein each mobile transverse chamber is configured to maintain a specified gas condition during the conveyance of the substrates. The transverse substrate handler further includes a rail for supporting the mobile transverse chambers, wherein the rail is positioned adjacent to entry of the process modules, and drive systems for moving the mobile transverse chambers on the rail.

WO 2009/150239 A1 discloses a cluster tool that can be used to form electronic circuits on a substrate in an automated fashion. The cluster tool is adapted to process portions of a substrate to form part of a photovoltaic cell or a green-tape circuit devices in an automated fashion using a system controller. The cluster tool has a plurality of work stations that comprise at least one station to deposit a layer on a substrate, a drying oven to dry the substrates, a testing station to test the substrates, a storage station to store the substrates, and a substantially closed circuit along which a plurality of transport elements are able to move, on each of which at least one of the substrates is disposed.

WO 2009/029901 A1 discloses a sectioning module positioned within an automated solar cell device fabrication system. The module comprises an inlet conveyor configured to receive commands from a system controller and transfer a solar cell device into a scribing station of the module, a scribing mechanism configured to receive commands from the system controller and scribe a pattern into a first surface of the solar cell device, a first positioning mechanism configured to receive commands from the system controller and accurately position the scribed solar cell device over a first break mechanism, and a first actuator configured to receive commands from the system controller and raise the first break mechanism.

The conventional systems, however, have the disadvantage that they are very long in one direction, such as about 19 meters long for a productive capacity of about 15 MW, to about 43 meters long for a productive capacity of about 150 MW. The conventional systems, therefore, require very large spaces to support the system and trolley related hardware, and a considerable investment in infrastructure to support the system, which all will generally increase the unitary cost of each photovoltaic module that is produced in the conventional system.

One possible objective of the present invention described below is to achieve a system for the production of photovoltaic modules that has a smaller linear length and smaller footprint so that the unitary cost of production of each photovoltaic module is reduced relative to conventional photovoltaic module processing systems.

Another purpose of the present invention is to achieve a system for the production of photovoltaic modules that is completely automated and also increases the photovoltaic module formation throughput, to increase the production capacity of the system, while requiring the same or smaller investment in the production related hardware and infrastructure.

Another purpose of the present invention is to improve a method for the production of photovoltaic modules in which the photovoltaic module formation process is simplified, while even utilizing a completely automated process, so as to keep production costs to a minimum.

The Applicant has devised, tested and embodied the present invention to overcome the shortcomings of the state of the art and to obtain these and other purposes and advantages.

### SUMMARY OF THE INVENTION

The present invention is set forth and characterized in the independent claim, while the dependent claims describe other characteristics of the invention or variants to the main inventive idea.

In accordance with the above purposes, a system for the production of photovoltaic modules according to the present invention comprises at least a first work line having at least a plurality of positioning stations in which various first processing operations are performed, in series, in order to make a photovoltaic module that comprises several different layers. The process sequence may include, for example, printing a layer material used to form one or more electric contacts on a base layer, and then positioning photovoltaic cells and various layers of insulating material in a desired orientation over the base layer to form a photovoltaic module.

According to a characteristic feature of the present invention, the system also comprises at least a second work line comprising at least another positioning station, in which at least another series of second processing operations is performed to make the photovoltaic module, in parallel with the various first processing operations as discussed above. In one configuration, the first work line is disposed substantially parallel to the second work line.

According to another characteristic feature of the present invention, the second work line comprises at least a positioning station for processing one or more layers of an insulating material used in the photovoltaic module. The positioning station may include a cutting device that is used to selectively cut to size each layer of insulating material received from a roll of insulating material.

According to another characteristic feature of the present invention, a first transport device, for example consisting of one or more conveyor belts, are provided to transport the layers of insulating material cut to size by the cutting device within the second work line.

According to another characteristic feature of the present invention of the second transport device is provided to selectively transport a layer of insulating material cut to size from the second work line to the first work line along a first axis transverse to the two work lines. In one configuration, the second transport device comprises a plate having a plurality through holes formed therein.

According to another characteristic feature of the present invention, a hole forming device is disposed along the first transverse axis to selectively form one or more holes through the layer of insulating material, during its transfer from the second work line to the first work line.

According to one embodiment of the present invention, the method for the production of photovoltaic modules generally comprises at least a first operation during which at least a first layer is loaded onto a first positioning station, and a second operation in which a plurality of electric contacts are deposited on a surface of the first layer by use of a printing process, wherein the plurality of printed electric contacts are suitable to subsequently contact at least a plurality of photovoltaic cells. Embodiments of the invention may further provide, a method that comprises at least another additional processing operation, which takes place in parallel with the first two operations and within the second work line, in which a plurality of layers of insulating material are prepared so that they are selectively coupled with the first layer and with the photovoltaic cells.

### BRIEF DESCRIPTION OF THE DRAWINGS

So that the manner in which the above recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.
Figure 1 is a plan view of a system used to form photovoltaic modules according to one embodiment of the invention.
Figure 2 is an exploded side view of a photovoltaic module suitable to be produced by the system in Figure 1 according to one embodiment of the invention.
Figure 3 is a plan view of a first zone of the system in Figure 1 according to one embodiment of the invention.
Figure 4 is a perspective view of a robotic device used in the first zone in Figure 3 according to one embodiment of the invention.
Figure 5 is a schematic side view of a detail of the first zone illustrated in Figure 3 according to one embodiment of the invention.
Figure 6 is a plan view of a second zone of the system illustrated in Figure 1 according to one embodiment of the invention.
Figure 7 is a partial cross-sectional view, along section line VII -VII illustrated in Figure 6, which schematically illustrates a punching device according to one embodiment of the invention.
Figure 8 is a schematic close-up front view of a series of punches used by the punching device illustrated in Figure 7 according to one embodiment of the invention.
Figure 9 is a schematic plan view of a first processing operation that may be carried out in the second zone of Figure 6 according to one embodiment of the invention.
Figure 10 is a schematic plan view of a second processing operation that may be carried out in the second zone of Figure 6 according to one embodiment of the invention.
Figure 11 is a plan view of a third zone of the system illustrated in Figure 1 according to one embodiment of the invention.
Figure 12 illustrates a processing sequence that can be used to produce photovoltaic modules using the system illustrated in Figure 1 according to one embodiment of the invention.

To facilitate understanding, identical reference numerals have been used, where possible, to designate identical elements that are common to the figures. It is contemplated that elements and features of one embodiment may be beneficially incorporated in other embodiments without further recitation.

### DETAILED DESCRIPTION

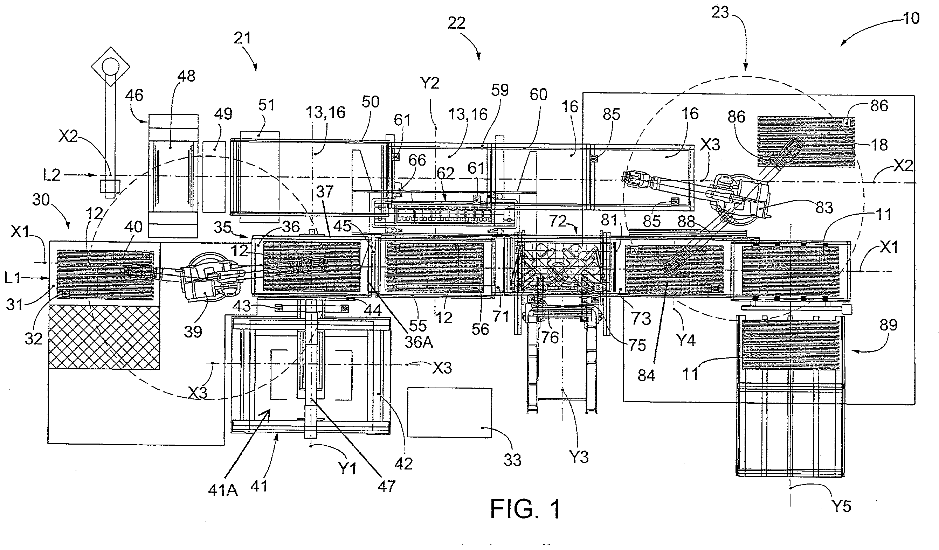

Embodiments of the invention generally include methods and apparatuses for forming a low cost photovoltaic module that contains one or more photovoltaic devices, or solar cells, within a processing system, or system 10 hereafter. Figure 1 is a plan view of a system 10 which is used to produce photovoltaic modules 11 that contain a plurality of solar cells of a known type, for example of the type described in the commonly assigned Italian patent application number UD2010A000223, which was filed December 2, 2010.

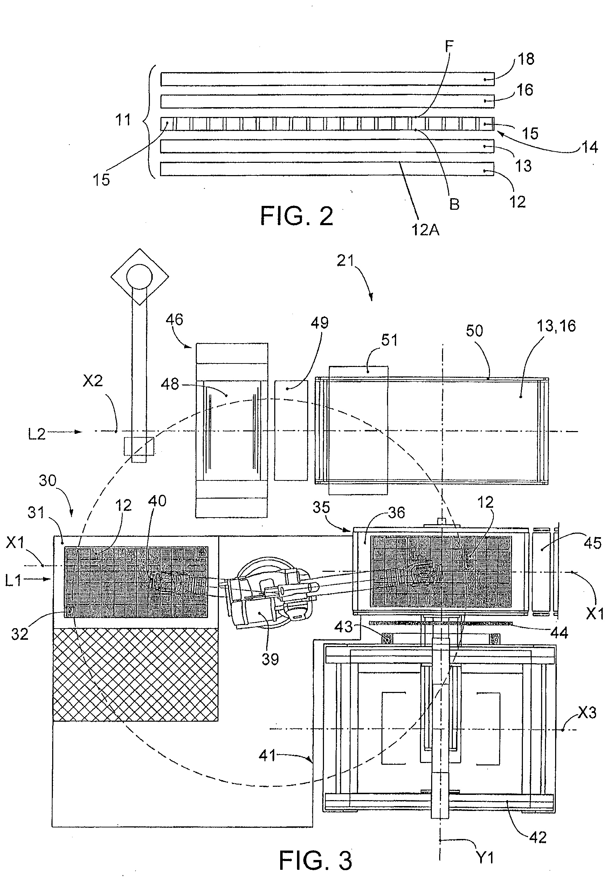

In general, the photovoltaic module 11 consists of a multi-layer structure (shown in Figure 2), which comprises a first lower layer 12, consisting of a flexible pre-printed electric circuit containing substrate, commonly called a "backsheet" or a "backfoil". The first lower layer 12 generally has a plurality of conductive tracks that are pre-printed on a connection surface 12A of the first lower layer 12, for example by screen-printing, using a conductive metal paste or ink.

Above the first layer 12, a second layer 13 of insulating material is positioned. In one example, the second layer 13 comprises a polymeric material, such as ethylene vinyl acetate (EVA). The second layer is often called an "encapsulant" layer, since it is used to help prevent moisture and other contamination from attacking components found in the photovoltaic module during its useable lifetime.

On the second layer 13, a third layer 14, or intermediate layer, which consists of a plurality of photovoltaic cells 15, is disposed. Typical types of photovoltaic cells that may be used herein, for example of the MWT (Metal Wrap Through) type of crystalline photovoltaic cell are further described in detail in the aforesaid patent application number UD2010A000223. For example, each photovoltaic module 11 comprises an array of photovoltaic cells 15 having a front surface F, suitable to be exposed to the light, and a rear surface B. Typically, the encapsulant layer 12 contains a plurality of holes, or vias, that allow electrical connections to be made between each of the photovoltaic cells 15 and the conductive tracks formed on the first lower layer 12.

Above the third layer 14, a fourth layer 16 of insulating material, for example EVA, is positioned, which also functions as an encapsulant, like the second layer 13. In this way, the photovoltaic cells 15 are disposed between the two layers of encapsulants 13 and 16.

A fifth layer 18 of transparent protective material, for example glass, is disposed above the fourth layer 16.

### Photovoltaic Module Production System

Referring to Figure 1, the system 10, which is used to form the aforementioned photovoltaic modules 11, is generally divided into three zones, or first, second and third regions 21, 22 and 23, respectively, which are disposed in sequence (from left to right in Figure 1). The photovoltaic modules 11 generally move downstream as they are sequentially processed in the first, second and third regions 21, 22 and 23. Furthermore, the system 10 comprises two work lines L1 and L2, disposed along two longitudinal axes X1 and X2, or also referred to herein as a first axis X1 and second axis X2, which are substantially parallel to each other. In general, all of the processes performed in the system 10 are monitored and controlled by a control unit 33.

The first region 21, illustrated in Figures 1 and 3, comprises a first positioning station 30, disposed along the first work line L1, in which a plurality of first layers or backsheets 12 are prepared and stacked. Figure 3 is a close-up plan view illustrating the first region 21 of the system 10 shown in Figure 1. The first positioning station 30 comprises a first support device 31, which is able to be selectively oriented, and a first optical control device 32. The first optical control device 32 generally comprises a digital camera and other conventional supporting electronics and optical devices that are able to optically detect and verify the exact position of a backsheet 12. The first optical control device 32 is generally adapted to detect the spatial coordinates and/or orientation of a backsheet 12 and transmit them, in digital form, to a control unit 33 (Figure 1), for further analysis and processing. Based on the information detected by the optical control device 32, the support device 31 is selectively oriented and/or positioned in the three spatial coordinates x, y and θ (theta for rotation) by use of commands sent from the control unit 33.

The first region 21 also comprises a second positioning station 35, also disposed along the first work line L1 and comprising a second support device 36, which, unlike the first support device 31, can be selectively oriented according to the three spatial coordinates x, y and θ, and also translatable along a first transverse axis Y1, which is perpendicular to the longitudinal axis X1. The second support device is generally translatable along the first transverse axis Y1 by use of one or more actuators (*e.g.*, electric motors and conventional mechanical guides, slides or other supporting components). The second support device 36 is also typically provided with a conveyor belt 37 that can be selectively driven to move and/or reposition the photovoltaic module components disposed thereon. During operation, a backsheet 12 is transferred from the first positioning station 30 to the upper part of the conveyor belt 37 of the second support device 36 by use of a first robotic device 39.

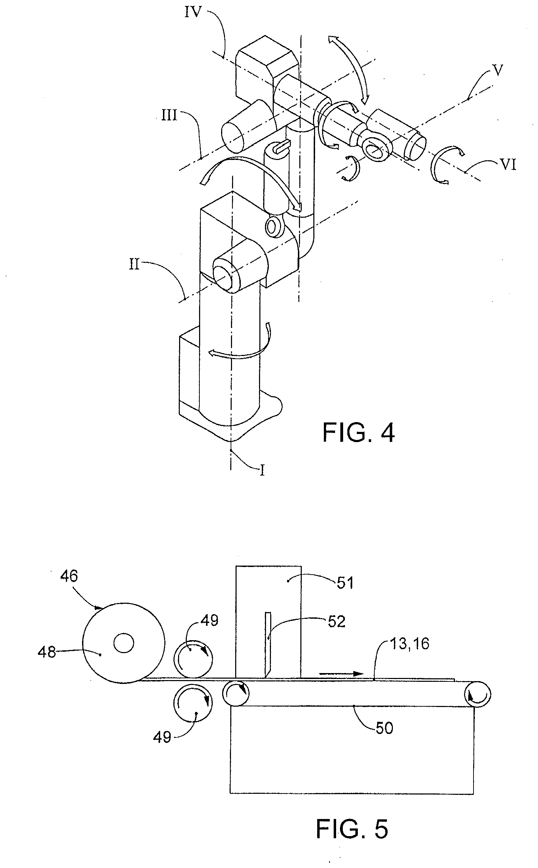

The first robotic device 39 may be a six axis robot, which is shown schematically in Figures 1, 3 and 4, which is generally suitable to take one backsheet 12 at a time from the first positioning station 30 and transfer it to the second support device 36 in the second positioning station 35 by use of commands sent from the control unit 33. In particular, the robot 39 comprises a terminal arm 40 provided with gripping elements on which a vacuum is selectively created so as to pick up, transport and release a backsheet 12.

Furthermore, the first region 21 may comprise a print station 41, disposed longitudinally along a third longitudinal axis X3, which is parallel to the longitudinal axes X1 and X2, and transversely along the first transverse axis Y1. The print station 41 comprises a print device 42 of a known type, for example of the screen printing device, or ink jet device, which is suitable to deposit a patterned layer of a conductive material and/or adhesive material, hereafter referred to as an ECA (Electrically Conductive Adhesive). In one example, the print station 41 is configured to deposit an ECA paste, such as a copper, silver or other similar metal containing polymeric material, in a desired pattern on the backsheet 12 to form the necessary electric contacts between portions of the backsheet 12 and regions of the rear surfaces B (Figure 2) of the photovoltaic cells 15 of the third layer 14. In one embodiment, the screen print chamber includes a plurality of actuators (*e.g.*, stepper motors or servomotors) that are in communication with the control unit 33 and are used to adjust the position and/or angular orientation of a screen printing mask disposed within the screen print chamber with respect to a backsheet 12 being printed. In one embodiment, the screen printing mask is a metal sheet or plate with a plurality of features, such as holes, slots, or other apertures formed therethrough to define a pattern and placement of screen printed material (*i.e.*, ink or paste) on a surface of a backsheet 12. In general, the screen printed pattern that is to be deposited on the surface of a backsheet 12 is aligned to the backsheet 12 in an automated fashion by orienting the screen printing mask in a desired position over its surface using the actuators and information received by the control unit 33 from a second optical control device 43, which is discussed below, and then urging the material to be deposited on the backsheet 12 through the apertures formed in the screen printing mask using a squeegee type device.

A second optical control device 43, which may comprise one or more cameras that are connected to the control unit 33, is positioned to detect the spatial coordinates and/or orientation of a backsheet 12 that is disposed on the second support device 36, when the second support device 36 translates under second optical control device 43, along the transverse axis Y1, to the print device 42. The backsheet 12 may be translated along the transverse axis Y1 by use of an actuation device 47 (Figure 1) that is coupled to the second support device 36.

The second optical control device 43 and control unit 33 are able to acquire the position of a backsheet 12 and correct the alignment of the backsheet 12 relative to the print device 42, by controlling the position and orientation of the support device 36.

After printing the patterned layer of a conductive material and/or adhesive material, the second support device 36 is translated along the axis Y1 until it is returned to its original position, and thus, is aligned with the first longitudinal axis X1.

A third optical control device or viewing system 44, which is also connected to the control unit 33 and positioned near the second optical control device 43, can be used to verify the quality (*e.g.*, size, shape or other feature of one or more regions of the patterned layer) and/or the position of the printed patterned layer of material after it has been formed on a backsheet 12 by the print device 42.

Next a feed roller 45 can be used to transfer the backsheet 12, with the patterned layer of material (*e.g.*, patterned layer of ECA) on it, from the second support device 36 to the second region 22 of the system 10.

In some configurations, the first region 21 may also comprise a third positioning station 46 that is disposed along the second work line L2. The second work line L2 is generally adapted to perform a plurality of processing operations, such as preparing the various encapsulants (*e.g.*, second layers 13 and the fourth layers 16) for use within the photovoltaic modules 11 (Figure 2). In particular, a strip of a polymeric material, such as EVA, that is wound around a roll 48 (Figures 1, 3 and 5) is unwound by one or more drawing rollers 49 and transferred to a conveyor belt 50 and a cutting unit 51 to cut the strip of polymeric material to size. In one example, the strips, or sheets, of encapsulants 13 and 16 are cut to size by use of a blade 52 disposed in the cutting unit 51 so that each strip of material used to form the encapsulant 13 or 16 has the same shape and/or surface area as the backsheet 12.

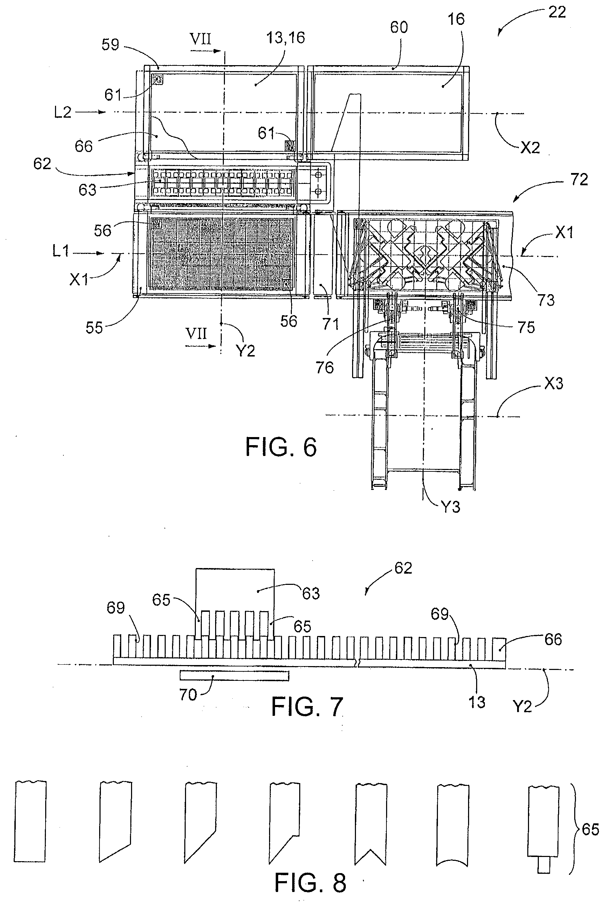

The second region 22, illustrated in Figures 1 and 6, comprises a third support device 55, similar to the second support device 36, also disposed along the first work line L1, and on which each backsheet 12 with the ECA material can be positioned for a subsequent processing. The third support device 55 is disposed longitudinally along the first longitudinal axis X1 direction and transversely along a second transverse axis Y2, which is parallel to the first transverse axis Y1. The third support device 55 is connected to the control unit 33, and can be selectively oriented according to three spatial coordinates x, y and θ, and also is translatable along a second transverse axis Y2. A fourth optical control device 56 may be disposed above the third support device 55 to detect the position of a backsheet 12 resting on it, and/or the position of an encapsulant 13 disposed upon a backsheet 12, as will be described hereafter.

The second region 22, as illustrated in Figures 1 and 6, may also include two conveyor belts 59 and 60, which are part of the second work line L2, and are both aligned longitudinally along the second longitudinal axis X2, that is, in line with the conveyor belt 50. The conveyor belts 59, 60 are controlled by commands sent by the control unit 33. The conveyor belt 59, is transversely disposed along the second transverse axis Y2 and is suitable to receive the encapsulants 13 and 16 that arrive from the conveyor belt 50 in the first region 21. A fifth optical control device 61, connected to the control unit 33, is disposed in a fixed position above the conveyor belt 59 to detect the position of each encapsulant 13 and 16 resting upon the conveyor belt 59.

A hole forming, or punching device 62 (Figures 1, 6 and 7), is disposed between the conveyor belt 59 and the third support device 55. Figure 7 is a side cross-sectional view of a punching device 62 that may include a punch head 63 and a punch plate 66. The punch head 63 may include a plurality of punches 65 that are disposed vertically, and each having a determinate diameter, to achieve a plurality of holes in each encapsulant 13 that are formed in a desired matrix of rows and columns, or other desirable pattern. The shape of the hole formed by each punch 65 can be any shape depending on the punching requirements. Figure 8 illustrates some examples of some possible shapes, but is not intended to be limiting as to the scope of the invention described herein.

The punch plate 66 of the punching device 62, which is provided with a plurality of transverse through holes 69 (Figure 7), is disposed according to a matrix of rows and columns, identical to the holes to be made within each encapsulant 13. The plurality of through holes 69 in the plate 66 are disposed horizontally between the punch head 63 and an abutment plate 70, which is found in a fixed position under the punch head 63. The holes 69 formed in the plate 66 are configured to receive the punches 65 disposed in the punch head 63 so that holes are formed within the encapsulant 13, during the punching operation. The plate 66 is also provided with other vacuum holes, parallel to the holes 69 (not shown), through which, in a known manner, a vacuum is selectively created on the lower surface of the plate 66, so as to hold an encapsulant 13 by causing it to adhere to the lower surface of the plate 66.

The plate 66 is mobile transversely between the work lines L1 and L2, along the transverse axis Y2 (Figures 6 and 7). The plate 66 can be positioned between a first position, which is above the conveyor belt 59, and a second position in which it is above the third support device 55 by use of an actuation device. During the process of transferring the plate 66 between the first position and the second position it passes between a plurality of intermediate positions, under the punch head 63. The plate 66 is positioned by a conventional motor, of a known type that is not shown in the drawings, by use of commands sent from the control unit 33 (Figure 1).

During operation, the punch head 63 (Figure 7) is able to form a plurality of holes simultaneously in each encapsulant 13, for example, six holes at a time. During operation, the plate 66 advances in a step-wise fashion so that in a determinate number of passes, for example, six passes, the punch head 63 can form all of the holes in an encapsulant 13.

After the holes are formed in the encapsulant 13, it is transferred by the plate 66 to a position above a backsheet 12 that is already positioned on the third support device 55. The fourth optical control device 56 verifies the position of the encapsulant 13, with respect to the backsheet 12, and if needed, by means of the control unit 33, aligns the backsheet 12 with the encapsulant 13. The position of the backsheet 12 is verified by the fifth optical control device 61.

Once the encapsulant 13 is aligned with the backsheet 12 below, the vacuum created within the vacuum holes in the plate 66 by a vacuum source (*e.g.*, vacuum pump) is interrupted, and the encapsulant 13 descends, due to gravity, until it rests on the backsheet 12, and the previously deposited ECA disposed on the backsheet 12 are positioned in the holes made in the encapsulant 13.

A feed roll 71, also controlled by the control unit 33, is disposed along the first work line L1, downstream of the third support device 55, and is suitable to transfer a backsheet 12 provided with adhesive electric contacts (*e.g.*, ECA) and an encapsulant 13 disposed thereon, towards a fourth positioning station 72. The fourth positioning station 72 is disposed along the first work line L1, and is configured to position a plurality of photovoltaic cells 15 over the positioned encapsulant 13 layer.

The fourth positioning station 72 comprises a conveyor belt 73 and two robotic devices, respectively second and third 75 and 76 (Figures 6, 9 and 10), which may each comprise a 6 axis robot, which may be similar to the first robotic device 39, and is also controlled by the control unit 33.

A conveyor belt 73 (Figure 1) is disposed longitudinally along the first longitudinal axis X1 and defines an upper plane on which the combined backsheet 12 and encapsulant 13 is disposed. In some configurations, the conveyor belt 73 is positioned in a first transverse position defined by a third transverse axis Y3, which is parallel to the axes Y1 and Y2.

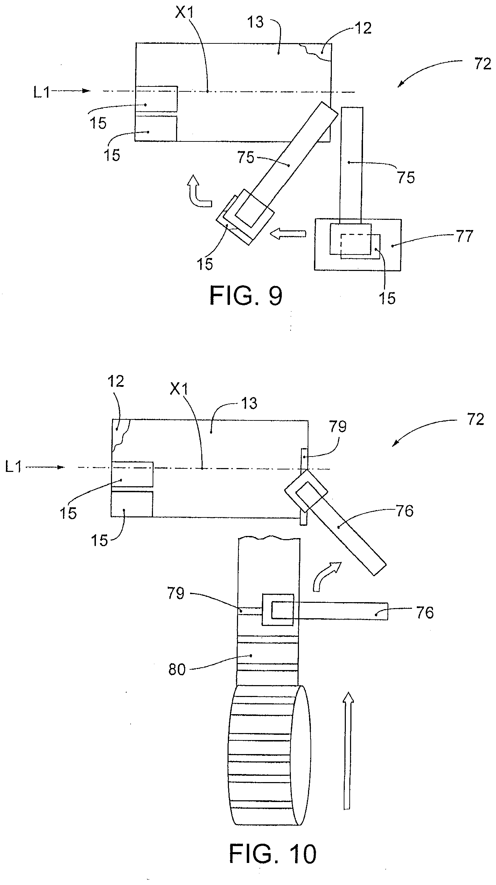

The second robotic device 75 (Figure 9), is configured to pick up each photovoltaic cell 15, by means of a selective vacuum gripping device, from a buffer (not shown), and to place each photovoltaic cell 15 in a determinate position over the encapsulant 13. A conventional viewing system (not shown) is also associated with the robotic device 75, to verify the position of each photovoltaic cell 15 on the encapsulant 13, by reading appropriate markers or fiducials present on each photovoltaic cell 15, or the edges of the substrate. During this step, the viewing system is also used to optically inspect each of the photovoltaic cells 15, so as to verify their quality (*e.g.*, no breakages). Based on the measured coordinates of the backsheet 12 and the individual photovoltaic cells 15, the control unit 33 and robotic device 75 are able to position each of the photovoltaic cells 15 with extreme accuracy and precision on the encapsulant 13. The robotic device 75 is also suitable to discard the defective photovoltaic cells 15, by transferring them to a suitable waste container, of a known type and not shown in the drawings.

The third robotic device 76 (Figure 10), which may comprise two independent robots, is configured to pick up, one at a time, a plurality of ribbons 79 and position them on the edges and in the assigned zones within each photovoltaic module 11, so as to form a desired pattern of electric contacts. The third robotic device 76 can be configured to pick-up and transfer the ribbons 79 by use of a selective vacuum chucking device. In general, the ribbons 79 may comprise of conductive material, such as a metal formed into a patterned foil, strip and/or sheet, such as strips 80 that are gradually unwound from a roll (not shown).

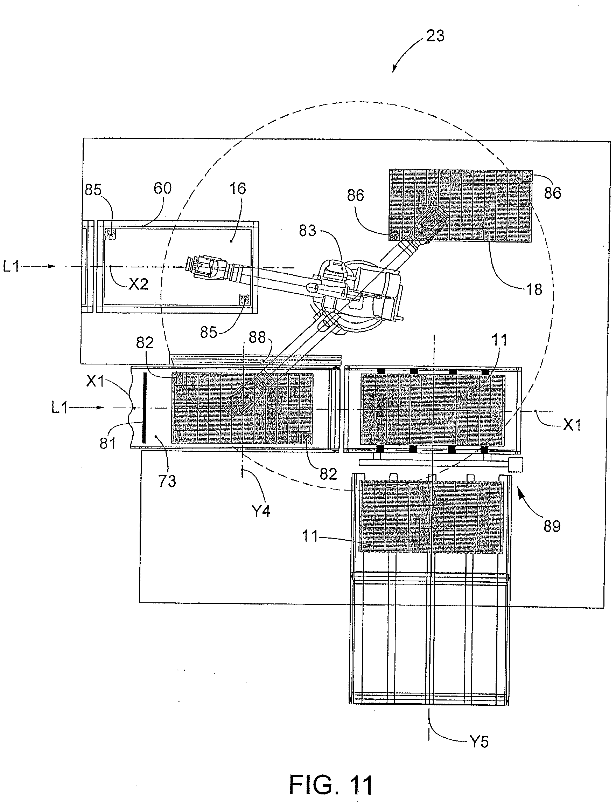

The portion of the photovoltaic module, that now consists of the backsheet 12, which comprises the backsheet 12 with the ECA contacts, the patterned encapsulant 13, the photovoltaic cells 15 and of the ribbons 79, are then transferred by the conveyor belt 73, by use of the control unit 33, to a third region 23 (Figures 1 and 11). The third region 23 is located in a second transverse position along the first and/or second work lines L1, L2 defined by a fourth transverse axis Y4, parallel to the axes Y1, Y2 and Y3.

A sixth optical control device 81 is disposed in a fixed position, above the conveyor belt 73, to verify the quality or accuracy of the positioning of the photovoltaic cells 15 and the ribbons 79, before the subsequent processing operations are performed.

The third region 23 (Figure 11) comprises a seventh optical control device 82, which is disposed above the conveyor belt 73, downstream of the sixth optical control device 81, and is suitable to detect the position of the portion of the photovoltaic module arriving from the second region 22, with respect to the axes X1 and Y4, by use of commands sent by the control unit 33.

The third region 23 (Figure 11) also comprises a fourth robotic device 83 that is controlled by the control unit 33, and is configured to pick up a sheet of an encapsulant 16, disposed in a final position of the conveyor belt 60 along the second work line L2, and to position it above the portion of the photovoltaic module that is positioned in the second transverse position (axes X1, Y4), of the first work line L1. The fourth robotic device 83 may comprise a 6-axis robot, which is similar to the first robotic device 39, that has a vacuum chucking device that is adapted to pickup and transfer the sheet of encapsulant 16 from the conveyor belt 60 to the second transverse position 84.

An eighth optical control device 85, also connected to the control unit 33, is suitable to detect the position of the encapsulant 16 when it is disposed at the final position of the conveyor belt 60.

The fourth robotic device 83 is adapted to pick up, using a vacuum chucking device, one layer of glass 18 at a time, from a corresponding stack of layers of glass 18, and subsequently to position it over the encapsulant 16 on the formed stack already positioned in the second transverse position (axes X1, Y4). The placement of the layer of glass 18, so as to complete a module 11, that contains the previously discussed five layers. A ninth optical control device 86, also connected to the control unit 33, is adapted to detect the position and orientation of the layer 18 of glass before being picked up from the corresponding stack.

In correspondence with the second transverse position (axes X1, Y4), a heating device 88, which may comprise an infrared heating element, electric resistance heating element, hot air delivering device or other suitable heating device, is used to perform a pre-baking or pretaking operation of the photovoltaic module 11. During this process, the heat or energy delivered from the heating device 88 is used to at least partially melt the insulating material (EVA) found in the encapsulant 13 and 16 layers, so that the other layers 12, 14 and 18 are at least partially positionally fixed within the photovoltaic module 11.

Downstream of the conveyor belt 73 a photovoltaic module flipper device 89 is disposed transversely along a fifth transverse axis Y5, which is parallel to the axes Y1-Y4. The flipper device 89 is generally a robotic element that is configured to flip each formed photovoltaic module 11 into a desired orientation. In one example, the flipper device 89 is configured to flip the photovoltaic module 11 180°, so that the layer 18 of glass is disposed downward and it is ready to proceed to a subsequent rolling operation.

### Processing Sequence Example

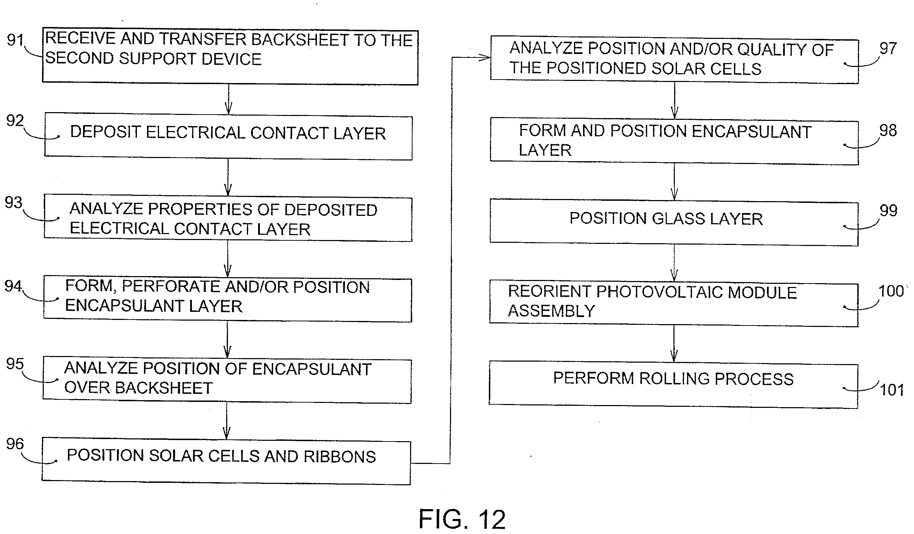

In one embodiment of the invention, as illustrated in Figure 12, a method of forming photovoltaic modules 11 in the system 10 may comprise the following processing operations. First, at operation 91, the backsheets 12 are loaded into; or received by, the first support device 31, which is found in the first work line L1. During this operation, the robot 39 is also used to transfer a backsheet 12 from the first support device 31 to the second support device 36, which is found in the second positioning station 35. During this operation, the optical control device 32 and the control unit 33 can be used to help assure that the backsheet 12, which is transferred from the first support device 31, is properly oriented and positioned on the second support device 36 by the robot 39.

Next, at operation 92, after being delivered to the print station 41 by the second support device 36, a surface of the backsheet 12 will have the necessary electric contacts, which are suitable to contact the photovoltaic cells 15 and the ribbons 79, is deposited thereon, by use of the components found in the print station 41. During this operation the second support device 36 is translated along the Y1 axis from a backsheet receiving position 36A to a processing position 41A under the print station 41 by use of the actuation device 47 (e.g., linear motor). The second optical control device 43 and control unit 33 can be used to orient the backsheet 12 relative to the print station 41 so that material deposited on the surface of the backsheet 12 will be properly aligned and positioned.

Next, at operation 93, the viewing system 44 and control unit 33 are used to inspect the quality and position of the printed patterned layer of material after it has been formed on the backsheet 12 by the print device 42. Then a device, such as the feed roller 45, is used to transfer the backsheet 12 to the third support device 55 of the second region 22 of the system 10.

Next, at operation 94, which is typically performed in parallel with the other operations performed in the system 10, for example simultaneously with the first three operations 91, 92 and 93, the encapsulants 13 and 16 are formed by the cutting unit 51, and then perforated with holes by the punching device 62. Then the cut and perforated encapsulant 13, is disposed over the backsheet 12 by use of the plate 66 and conventional motor, as discussed above, so that the holes formed in the encapsulant 13 are desirably positioned relative to the printed patterned layer of material disposed on the backsheet 12.

Next, at operation 95, the fourth optical control device 56 and control unit 33 are used to inspect the backsheet 12 and encapsulant 13 to assure that they are positioned correctly relative to each other, and/or positioned correctly within the system 10.

Next, at operation 96, the two robotic devices 75 and 76 are used to position the photovoltaic cells 15 and the ribbons 79 over the encapsulant 13, which has already been disposed over the backsheet 12.

Next, at operation 97, the sixth optical control device 81 is used to verify the quality of the positioning of the photovoltaic cells 15 and the ribbons 79, before the subsequent processing operations are performed. After performing this optical inspection operation the backsheet 12, and other components, are transferred to the third region 23 by use of a transferring device, such as the conveyor belt 73.

Next, in operation 98, the fourth robotic device 83 is used to position a non-patterned encapsulant material, such as encapsulant 16, over the photovoltaic cells 15 and ribbons 79.

Next, in operation 99, the fourth robotic device 83 is used to position a layer 18 of glass on the encapsulant 16, which is positioned over the photovoltaic cells 15 and the ribbons 79 that are positioned over the backsheet 12. At the end of operation 99, the photovoltaic module 11 is pre-baked, by delivering heat from the heating device 88 to the photovoltaic module 11 assembly to cause the encapsulant layers 13, 16 (e.g., EVA) disposed therein to soften and/or at least partially melt.

Next, in operation 100, the photovoltaic module 11, which was formed in operation 99, is flipped by the flipper device 89, so that the layer 18 of glass becomes the supporting layer for the photovoltaic module 11.

Next, at operation 101, the photovoltaic module 11 is subjected to a rolling process in which any trapped air that is disposed between the various layers in the photovoltaic module 11 is removed and/or the encapsulant layers 13, 16 are compressed to form a sealed photovoltaic module 11 that will protect and prevent the electrical connections and photovoltaic cells 15 from environmental attack during the formed photovoltaic module's useable lifetime. In one example, the rolling process includes delivering the photovoltaic module 11 through a pair of rollers that are adapted to apply a desired amount of force to opposite sides of the photovoltaic module 11, while it is heated to a desired processing temperature by one or more lamps (not shown).

If the formed photovoltaic module 11 is found to have undesirable imperfections in any of the layers, then the rejected photovoltaic module 11 can easily be discarded by transferring it to the end of the work line L1 so that it falls into a waste container (not shown) that is positioned to receive these rejected modules.

All the operations 91-101 in the processing sequence described above can carried out by use of commands sent from the control unit 33.

As discussed above, the system 10 may comprise at least two work lines that are adapted to perform one or more photovoltaic module formation tasks, or processing operations, in parallel to form a photovoltaic module 11.

By use of the one or more embodiment disclosed herein, the overall sizes of the system 10 are much smaller than other conventional photovoltaic module formation systems. In one example, a system 10, which is discussed above, that has a productive capacity of about 100 MW is between about 12m and about 15m in overall length. It is clear that modifications and/or additions of parts may be made to the system 10 for the production of photovoltaic modules as described heretofore, without departing from the field and scope of the present invention.

It is also clear that, although the present invention has been described with reference to a specific example, a person of skill in the art shall certainly be able to achieve many other equivalent forms of system and method for the production of photovoltaic modules, having the characteristics as set forth in the claims and hence all coming within the field of protection defined thereby.

## Claims

1. A system (10) for the production of photovoltaic modules, comprising:
a first work line (L1) comprising: two or more positioning stations (30, 35, 72) that are disposed along a first longitudinal axis (X1) and are each adapted to perform first photovoltaic module processing operations in series; and
a second work line (L2) comprising: at least one positioning station (46) that is aligned with a second longitudinal axis (X2) that is substantially parallel to the first longitudinal axis (XI), wherein the at least one positioning station (46) is adapted to perform another series of second photovoltaic module processing operations.

2. The system (10) of claim 1, wherein the two or more positioning stations (30, 35, 72) in the first work line (L1), further comprise:
a first positioning station (30) disposed along the first longitudinal axis (X1) and configured to receive a first layer of a photovoltaic module; and
a second positioning station (35) disposed along the first longitudinal axis (X1) and configured to receive the first layer, which is transferred from the first positioning station (30) by use of a first robotic device (39), wherein a print station (41) is disposed along a first transverse axis (Y1) that is transversely aligned to the first longitudinal axis (X1) and passes through the second positioning station (35).

3. The system (10) of claim 2, wherein the second positioning station (35) comprises a second support device (36) that has an actuator that is configured to orient and/or position the received first layer relative to the print station (41).

4. The system (10) of claim 1, wherein the second work line (L2) comprises at least a third positioning station (46) that is configured to selectively cut a layer of insulating material from a roll (48) to form one or more sheets of insulating material by use of a cutting device (51).

5. The system (10) of claim 4, wherein the second work line (L2) further comprises a device (62) that is adapted to form a plurality of holes in the one or more sheets.

6. The system (10) of claim 4, wherein the second work line (L2) further comprises a device (62) that comprises:
a punch head (63) having a plurality of punches (65); and
a plate (66) having a plurality of through holes (69) through which the punches (65) are able to pass, and a plurality of vacuum holes that are coupled to a vacuum source, wherein the vacuum holes are configured to cause one of the one or more sheets to adhere to a surface of the plate (66) when a pressure below atmospheric pressure is formed in the vacuum holes.

7. The system (10) of claim 2, wherein the first work line further comprises a fourth positioning station (72) that comprises a conveyor belt (73), a second robotic device (75) and a third robotic device (76), and wherein the third robotic device (76) is suitable to position a plurality of strips of a conductive material in predetermined zones of each photovoltaic module.

8. The system (10) of claim 7, further comprising a fourth robotic device (83) that is disposed in proximity to the end of the first and second work lines (L1, L2), and is configured to transfer a layer of an insulating material from the second work line (L2) to a second position in the first work line (L1), and wherein the fourth robotic device (83) is also configured to receive and transfer a layer.

9. A method of forming photovoltaic modules, comprising:
loading a first layer of the photovoltaic module onto a first support device (31) disposed in one of a plurality of positioning stations (30, 35, 72) disposed along a first longitudinal axis (X1) of a first work line (L1), and then positioning the first layer and the first support device (31) relative to a print station (41);
depositing a conductive material onto a surface of the first layer in the print station (41); and
preparing a first layer of insulating material, while loading the first layer or depositing a conductive material onto the surface of the first layer, wherein preparing the first layer of insulating material comprises cutting the insulating material to form a sheet, and cutting the insulating material is performed in one of a plurality of positioning stations (46) disposed along a second longitudinal axis (X2) of a second work line (L2).

10. The method of claim 9, further comprising:
positioning a plurality of photovoltaic devices over the surface of the first layer, wherein positioning the plurality of photovoltaic devices is performed in a first positioning station (30) in the first work line (L1), and loading the first layer of the photovoltaic module onto the first support device is performed in a second positioning station (35) in the first work line (L1).

11. The method of claim 10, further comprising:
positioning the prepared first layer of insulating material over the surface of the plurality of photovoltaic devices, wherein positioning the prepared first layer of insulating material includes transferring the first layer of insulating material from one of the plurality of positioning stations (46) in the second work line (L2) to one of the plurality of positioning stations (30, 35, 72) disposed in the first work line (L1).

12. The method of claim 9, further comprising:
inspecting the deposited conductive material using a first visual system (32) disposed in one of the plurality of positioning stations (30, 35, 72) in the first work line (L1), wherein inspecting the deposited conductive material comprises verifying the quality or the position of the deposited conductive material.

13. The method of claim 9, further comprising transferring and then disposing the first layer of insulating material over the surface of the first layer, wherein a plurality of holes are formed in the first layer of insulating material while it is transferred or disposed over the surface of the first layer.

14. The method of claim 11, further comprising: positioning a plurality of photovoltaic devices over the surface of the first layer, wherein positioning the plurality of photovoltaic devices is performed in a first positioning station (30) in the first work line (L1), and loading the first layer of the photovoltaic module onto a first support device (31) is performed in one of the plurality of positioning stations (30, 35, 72) in the first work line (L1).

15. The system (10) of claim 1, comprising:
the first work line (L1) disposed along the first longitudinal axis (X1) comprising the two or more positioning stations (30, 35, 72), wherein at least one of the positioning stations (30, 35, 72) of the first work line (L1) is configured to make at least one intermediate layer of the photovoltaic modules, and wherein the photovoltaic modules comprise a plurality of photovoltaic cells;
the second work line (L2) disposed along the second longitudinal axis (X2) parallel to the first longitudinal axis (XI), wherein the second work line (L2) comprises the at least one positioning station (46) configured to make at least one encapsulant layer of insulating material of the photovoltaic modules associated with the intermediate layer in parallel with the positioning stations (30, 35, 72) of the first work line (LI); and
wherein conveyor belts (59, 60) and a movable plate (66) are provided to selectively move the at least one encapsulant layer from the second work line (L2) to the first work line (L1) to associate the at least one encapsulant layer with the intermediate layer to make the photovoltaic module.

## Patentansprüche

1. System (10) zur Herstellung von Fotovoltaikmodulen, umfassend:
eine erste Fertigungslinie (L1), umfassend:
zwei oder mehr Positionierstationen (30, 35, 72), die entlang einer ersten Längsachse (X1) angeordnet sind und jede dafür ausgelegt ist, erste Fotovoltaikmodul-Verarbeitungsoperationen in Serie auszuführen; und
eine zweite Fertigungslinie (L2), umfassend: mindestens eine erste Positionierstation (46), die zu einer zweiten Längsachse (X2) ausgerichtet ist, welche im Wesentlichen parallel zur ersten Längsachse (X1) ist, wobei die mindestens eine Positionierstation (46) dafür ausgelegt ist, eine weitere Serie von zweiten Fotovoltaikmodul-Verarbeitungsoperationen auszuführen.

2. System (10) nach Anspruch 1, wobei die zwei oder mehr Positionierstationen (30, 35, 72) in der ersten Fertigungslinie (L1) ferner umfassen:
eine erste Positionierstation (30), die entlang der ersten Längsachse (X1) angeordnet ist und dafür ausgelegt ist, eine erste Schicht eines Fotovoltaikmoduls zu empfangen; und
eine zweite Positionierstation (35), die entlang der ersten Längsachse (X1) angeordnet ist und dafür ausgelegt ist, die erste Schicht aufzunehmen, die von der ersten Positionierstation (30) durch Verwendung einer ersten Robotervorrichtung (39) übertragen wurde, wobei eine Druckstation (41) entlang einer ersten Querachse (Y1) angeordnet ist, die quer zur ersten Längsachse (X1) ausgerichtet ist und durch die zweite Positionierstation (35) läuft.

3. System (10) nach Anspruch 2, wobei die zweite Positionierstation (35) eine zweite Stützvorrichtung (36) umfasst, die einen Aktor hat, der dafür ausgelegt ist, die empfangene erste Schicht relativ zur Druckstation (41) auszurichten und/oder zu positionieren.

4. System (10) nach Anspruch 1, wobei die zweite Fertigungslinie (L2) mindestens eine dritte Positionierstation (46) umfasst, die dafür ausgelegt ist, selektiv eine Schicht von Isoliermaterial von einer Rolle (48) abzuschneiden, um ein oder mehrere Bögen von Isoliermaterial durch Verwendung einer Schneidvorrichtung (51) zu bilden.

5. System (10) nach Anspruch 4, wobei die zweite Fertigungslinie (L2) ferner eine Vorrichtung (62) umfasst, die dafür eingestellt ist, mehrere Löcher in dem einen Bogen oder in den mehreren Bögen zu bilden.

6. System (10) nach Anspruch 4, wobei die zweite Fertigungslinie (L2) ferner eine Vorrichtung (62) umfasst, die umfasst:
einen Stanzkopf (63), der mehrere Stanzen (65) hat; und
eine Platte (66), die mehrere Durchgangslöcher (69) hat, durch die die Stanzen (65) passen, und mehrere Vakuumlöcher, die mit einer Vakuumquelle verbunden sind, wobei die Vakuumlöcher dafür ausgelegt sind, zu bewirken, dass ein oder mehrere Bögen an einer Fläche der Platte (66) haften, wenn ein Druck unterhalb des Atmosphärendrucks in den Vakuumlöchern gebildet wird.

7. System (10) nach Anspruch 2, wobei die erste Fertigungslinie ferner eine vierte Positionierstation (72) umfasst, die ein Transportband (73), eine zweite Robotervorrichtung (75) und eine dritte Robotervorrichtung (76) enthält, und wobei die dritte Robotervorrichtung (76) dafür geeignet ist, mehrere Streifen eines leitfähigen Materials in vorgegebenen Zonen jedes Fotovoltaikmoduls zu positionieren.

8. System (10) nach Anspruch 7, das ferner eine vierte Robotervorrichtung (83) umfasst, die in der Nähe des Endes der ersten und zweiten Fertigungslinie (L1, L2) angeordnet ist und dafür ausgelegt ist, eine Schicht eines Isoliermaterial von der zweiten Fertigungslinie (L2) zu einer zweiten Position in der ersten Fertigungslinie (L1) zu übertragen, und wobei die vierte Robotervorrichtung (83) ebenfalls dafür ausgelegt ist, eine Schicht aufzunehmen und zu übertragen.

9. Verfahren zum Bilden von Fotovoltaikmodulen, umfassend:
Laden einer ersten Schicht des Fotovoltaikmoduls auf eine erste Stützvorrichtung (31), die in einer der mehreren Positionierstationen (30, 35, 72) angeordnet ist, welche entlang einer ersten Längsachse (X1) einer ersten Fertigungslinie (L1) angeordnet sind, und dann Positionieren der ersten Schicht und der ersten Stützvorrichtung (31) relativ zu einer Druckstation (41) ;
Ablegen eines leitfähigen Materials auf einer Fläche der ersten Schicht in der Druckstation (41); und
Vorbereiten einer ersten Schicht von Isoliermaterial, während die erste Schicht geladen oder ein leitfähiges Material auf der Oberfläche der ersten Schicht abgelagert wird, wobei das Vorbereiten der ersten Schicht von Isoliermaterial das Schneiden des Isoliermaterials umfasst, um einen Bogen zu bilden, und das Schneiden des Isoliermaterial wird in einer der mehreren Positionierstationen (46) ausgeführt, die entlang einer zweiten Längsachse (X2) einer zweiten Fertigungslinie (L2) angeordnet sind.

10. Verfahren nach Anspruch 9, ferner umfassend:
Positionieren mehrerer Fotovoltaikvorrichtungen über der Fläche der ersten Schicht,
wobei das Positionieren der mehreren Fotovoltaikvorrichtungen in einer ersten Positionierstation (30) in der ersten Fertigungslinie (L1) ausgeführt wird, und das Laden der ersten Schicht des Fotovoltaikmoduls auf die erste Stützvorrichtung wird in einer zweiten Positionierstation (35) in der ersten Fertigungslinie (L1) ausgeführt.

11. Verfahren nach Anspruch 10, ferner umfassend:
Positionieren der vorbereiteten ersten Schicht von Isoliermaterial über der Fläche der mehreren Fotovoltaikvorrichtungen, wobei das Positionieren der vorbereiteten ersten Schicht von Isoliermaterial das Übertragen der ersten Schicht von Isoliermaterial von einer der mehreren Positionierstationen (46) in der zweiten Fertigungslinie (L2) auf eine der mehreren Positionierstationen (30, 35, 72), die in der ersten Fertigungslinie (L1) angeordnet sind, umfasst.

12. Verfahren nach Anspruch 9, ferner umfassend:
Inspizieren des abgelagerten leitfähigen Materials unter Verwendung eines ersten Sichtsystems (32), das in einer der mehreren Positionierstationen (30, 35, 72) in der ersten Fertigungslinie (L1) angeordnet ist, wobei das Inspizieren des abgelagerten leitfähigen Materials das Überprüfen der Qualität oder der Position des abgelagerten leitfähigen Materials umfasst.

13. Verfahren nach Anspruch 9, das ferner das Übertragen und dann Anordnen der ersten Schicht von Isoliermaterial auf der Fläche der ersten Schicht umfasst, wobei mehrere Löcher in der ersten Schicht von Isoliermaterial gebildet werden, während es auf die Fläche der ersten Schicht übertragen oder abgelagert wird.

14. Verfahren nach Anspruch 11, ferner umfassend:
Positionieren mehrerer Fotovoltaikvorrichtungen über der Fläche der ersten Schicht, wobei das Positionieren der mehreren Fotovoltaikvorrichtungen in einer ersten Positionierstation (30) in der ersten Fertigungslinie (L1) ausgeführt wird, und das Laden der ersten Schicht des Fotovoltaikmoduls auf eine erste Stützvorrichtung (31) wird in einer der mehreren Positionierstationen (30, 35, 72) in der ersten Fertigungslinie (L1) ausgeführt.

15. System (10) nach Anspruch 1, umfassend:
die erste Fertigungslinie (L1), die entlang der ersten Längsachse (X1) angeordnet ist, die zwei oder mehr Positionierstationen (30, 35, 72) umfasst, wobei mindestens eine der Positionierstationen (30, 35, 72) der ersten Fertigungslinie (L1) dafür ausgelegt ist, mindestens eine Zwischenschicht der Fotovoltaikmodule herzustellen, und wobei die Fotovoltaikmodule mehrere Fotovoltaikzellen enthalten;
die zweite Fertigungslinie (L2), die entlang der zweiten Längsachse (X2) parallel zur ersten Längsachse (X1) angeordnet ist, wobei die zweite Fertigungslinie (L2) die mindestens eine Positionierstation (46) umfasst, die dafür ausgelegt ist, mindestens eine Einkapselungsschicht aus Isoliermaterial der Fotovoltaikmodule herzustellen, die mit der Zwischenschicht verbunden ist, parallel zu den Positionierstationen (30, 35, 72) der ersten Fertigungslinie (L1); und
wobei Transportbänder (59, 60) und eine bewegliche Platte (66) vorgesehen sind, um selektiv die mindestens eine Einkapselungsschicht von der zweiten Fertigungslinie (L2) zur ersten Fertigungslinie (L1) zu bewegen, um die mindestens eine Einkapselungsschicht mit der Zwischenschicht zu verbinden, um das Fotovoltaikmodul herzustellen.

## Revendications

1. Système (10) pour la production de modules photovoltaïques, comprenant :
une première ligne de travail (L1) comprenant : deux stations de positionnement ou plus (30, 35, 72) qui sont disposées le long d'un premier axe longitudinal (X1) et sont chacune adaptées pour exécuter des premières opérations de traitement de module photovoltaïque en série ; et
une seconde ligne de travail (L2) comprenant : au moins une station de positionnement (46) qui est alignée avec un second axe longitudinal (X2) qui est sensiblement parallèle au premier axe longitudinal (X1), dans lequel la au moins une station de positionnement (46) est adaptée pour exécuter une autre série de secondes opérations de traitement de module photovoltaïque.

2. Système (10) selon la revendication 1, dans lesquels les deux stations de positionnement ou plus (30, 35, 72) dans la première ligne de travail (L1), comprennent en outre :
une première station de positionnement (30) disposée le long du premier axe longitudinal (X1) et configurée pour recevoir une première couche d'un module photovoltaïque ; et
une deuxième station de positionnement (35) disposée le long du premier axe longitudinal (X1) et configurée pour recevoir la première couche, qui est transférée à partir de la première station de positionnement (30) en utilisant un premier dispositif robotique (39), dans lequel une station d'impression (41) est disposée le long d'un premier axe transversal (Y1) qui est aligné transversalement au premier axe longitudinal (X1) et passe à travers la deuxième station de positionnement (35) .

3. Système (10) selon la revendication 2, dans lequel la deuxième station de positionnement (35) comprend un second dispositif de support (36) qui a un actionneur qui est configuré pour orienter et/ou positionner la première couche reçue par rapport à la station d'impression (41).

4. Système (10) selon la revendication 1, dans lequel la seconde ligne de travail (L2) comprend au moins une troisième station de positionnement (46) qui est configurée pour couper sélectivement une couche de matériau isolant à partir d'un rouleau (48) pour former une ou plusieurs feuilles de matériau isolant en utilisant un dispositif de coupe (51).

5. Système (10) selon la revendication 4, dans lequel la seconde ligne de travail (L2) comprend en outre un dispositif (62) qui est adapté pour former une pluralité de trous dans la ou les feuilles.

6. Système (10) selon la revendication 4, dans lequel la seconde ligne de travail (L2) comprend en outre un dispositif (62) qui comprend :
une tête de poinçon (63) ayant une pluralité de poinçons (65) ; et
une plaque (66) ayant une pluralité de trous traversants (69) à travers lesquels les poinçons (65) sont aptes à passer, et une pluralité de trous de vide qui sont couplés à une source de vide, dans lequel les trous de vide sont configurés pour amener l'une parmi la ou les feuilles à adhérer à une surface de la plaque (66) lorsqu'une pression inférieure à la pression atmosphérique est formée dans les trous de vide.

7. Système (10) selon la revendication 2, dans lequel la première ligne de travail comprend en outre une quatrième station de positionnement (72) qui comprend une bande convoyeuse (73), un deuxième dispositif robotique (75) et un troisième dispositif robotique (76), et dans lequel le troisième dispositif robotique (76) est adapté pour positionner une pluralité de bandes d'un matériau conducteur dans des zones prédéterminées de chaque module photovoltaïque.

8. Système (10) selon la revendication 7, comprenant en outre un quatrième dispositif robotique (83) qui est disposé à proximité de l'extrémité des première et seconde lignes de travail (L1, L2), et est configuré pour transférer une couche d'un matériau isolant de la seconde ligne de travail (L2) à une seconde position dans la première ligne de travail (L1), et dans lequel le quatrième dispositif robotique (83) est également configuré pour recevoir et transférer une couche.

9. Procédé de formation de modules photovoltaïques, comprenant :
charger une première couche du module photovoltaïque sur un premier dispositif de support (31) disposé dans l'une d'une pluralité de stations de positionnement (30, 35, 72) disposées le long d'un premier axe longitudinal (X1) d'une première ligne de travail (L1), et positionner ensuite la première couche et le premier dispositif de support (31) par rapport à une station d'impression (41) ;
déposer un matériau conducteur sur une surface de la première couche dans la station d'impression (41) ; et
préparer une première couche de matériau isolant, tout en chargeant la première couche ou en déposant un matériau conducteur sur la surface de la première couche, dans lequel la préparation de la première couche de matériau isolant comprend de couper le matériau isolant pour former une feuille, et la coupe du matériau isolant est réalisée dans l'une parmi une pluralité de stations de positionnement (46) disposées le long d'un second axe longitudinal (X2) d'une seconde ligne de travail (L2) .

10. Procédé selon la revendication 9, comprenant en outre :
positionner une pluralité de dispositifs photovoltaïques au-dessus de la surface de la première couche,
dans lequel le positionnement de la pluralité de dispositifs photovoltaïques est réalisé dans une première station de positionnement (30) dans la première ligne de travail (L1), et le chargement de la première couche du module photovoltaïque sur le premier dispositif de support est réalisé dans une seconde station de positionnement (35) dans la première ligne de travail (L1).

11. Procédé selon la revendication 10, comprenant en outre :
positionner la première couche de matériau isolant préparée au-dessus de la surface de la pluralité de dispositifs photovoltaïques, dans lequel le positionnement de la première couche de matériau isolant préparée inclut de transférer la première couche de matériau isolant de l'une de la pluralité de stations de positionnement (46) dans la seconde ligne de travail (L2) à l'une de la pluralité de stations de positionnement (30, 35, 72) disposées dans la première ligne de travail (L1).

12. Procédé selon la revendication 9, comprenant en outre :
inspecter le matériau conducteur déposé en utilisant un premier système visuel (32) disposé dans l'une de la pluralité de stations de positionnement (30, 35, 72) dans la première ligne de travail (L1), dans lequel l'inspection du matériau conducteur déposé comprend de vérifier la qualité ou la position du matériau conducteur déposé.

13. Procédé selon la revendication 9, comprenant en outre de transférer et ensuite de disposer la première couche de matériau isolant au-dessus de la surface de la première couche, dans lequel une pluralité de trous est formée dans la première couche de matériau isolant lorsqu'il est transféré ou disposé au-dessus de la surface de la première couche.

14. Procédé selon la revendication 11, comprenant en outre : positionner une pluralité de dispositifs photovoltaïques au-dessus de la surface de la première couche, dans lequel le positionnement de la pluralité de dispositifs photovoltaïques est réalisé dans une première station de positionnement (30) dans la première ligne de travail (L1), et le chargement de la première couche du module photovoltaïque sur un premier dispositif de support (31) est réalisé dans l'une de la pluralité de stations de positionnement (30, 35, 72) dans la première ligne de travail (L1).

15. Système (10) selon la revendication 1, comprenant :
la première ligne de travail (L1) disposée le long du premier axe longitudinal (X1) comprenant les deux stations de positionnement ou plus (30, 35, 72), dans lequel au moins l'une des stations de positionnement (30, 35, 72) de la première ligne de travail (L1) est configurée pour fabriquer au moins une couche intermédiaire des modules photovoltaïques, et dans lequel les modules photovoltaïques comprennent une pluralité de cellules photovoltaïques ;
la seconde ligne de travail (L2) disposée le long du second axe longitudinal (X2) parallèle au premier axe longitudinal (X1), dans lequel la seconde ligne de travail (L2) comprend la au moins une station de positionnement (46) configurée pour fabriquer au moins une couche d'encapsulation en matériau isolant des modules photovoltaïques associés à la couche intermédiaire parallèlement aux stations de positionnement (30, 35, 72) de la première ligne de travail (L1) ; et
dans lequel des bandes convoyeuses (59, 60) et une plaque mobile (66) sont prévues pour déplacer sélectivement la au moins une couche d'encapsulation de la seconde ligne de travail (L2) à la première ligne travail (L1) pour associer la au moins une couche d'encapsulation avec la couche intermédiaire pour fabriquer le module photovoltaïque.
